(19) Europäisches Patentamt / European Patent Office / Office européen des brevets

(11) **EP 2 670 034 A1**

(12) **EUROPEAN PATENT APPLICATION**

(43) Date of publication:
**04.12.2013 Bulletin 2013/49**

(51) Int Cl.:
**H02M 3/07** *(2006.01)*　　**G01R 31/36** *(2006.01)*

(21) Application number: **12170559.4**

(22) Date of filing: **01.06.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **NXP B.V.**
**5656 AG Eindhoven (NL)**

(72) Inventors:
• **Neuteboom, Harry**
**Redhill, Surrey RH1 1NY (GB)**

• **Straaten, Bram**
**Redhill, Surrey RH1 1NY (GB)**

(74) Representative: **Hardingham, Christopher Mark**
**NXP Semiconductors**
**Intellectual Property and Licensing**
**Red Central**
**60 High Street**
**Redhill, Surrey RH1 1SH (GB)**

(54) **Method and circuit for determining charge pump input current**

(57)　　A method is provided of determining the input current consumption of a capacitive DC/DC converter. This can be used for example to predict the battery life of a battery which supplies current to a load through the capacitive DC/DC converter. The converter is operated in cycles with timing dependent on the output voltage. The number of cycles during which the DC/DC converter is operated is counted and the current is derived from the number of cycles.

FIG. 8

EP 2 670 034 A1

**Description**

This invention relates to the measurement of the input current consumption of a DC/DC converter. In particular, the invention relates to battery operated devices using a DC/DC converter to power the device from the battery.

A hearing aid is for example supplied by a zinc-air battery. Capacitive DC/DC conversion is used to provide the required supply voltage for the hearing aid circuitry. The converter provides a regulated output voltage. For this application, high efficiency is needed and no external components are allowed.

The DC/DC converter typically comprises a switch mode power supply having a clock gating control loop. The converter is clocked when energy is required.

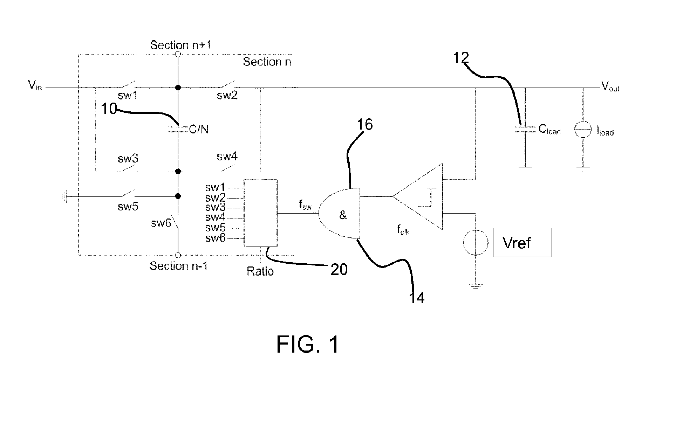

Figure 1 shows an example of the DC/DC converter circuit used.

The circuit is supplied by a battery with voltage Vin. A set of switches ws1 to sw6 and a storage capacitor 10 form the core of the DC/DC converter, and generate an output voltage Vout.

The switches control the transfer of charge to and from the capacitor 10. The capacitor is charged using charge flow from the input Vin and discharges to an output capacitor 12 (Cload). In this way, a voltage change as well as voltage regulation can be implemented.

The output voltage Vout (or a voltage derived from it) is compared with a reference voltage Vref by comparator 14 which determines when the switches need to operate. The reference voltage can for example be generated by a bandgap reference circuit. The output voltage Vout can be scaled using a resistive divider for comparison with the bandgap reference voltage.

A clock signal fclk is passed to the switches of the DC/DC converter core (shown schematically in Figure 1) only when enabled by the comparator 14. The comparator output and the clock signal fclk are provided to an adder 16 to derive the clock gating signal fsw. This is used to control all of the switches to provide the desired configuration of the capacitor.

The battery voltage slowly drops during its lifetime, for example from 1.4V to 0.9V. This leads to more switching in the DC/DC converter.

The invention provides an apparatus and method as defined in the independent claims.

According to the invention, there is provided a method of determining the input current consumption of a capacitive DC/DC conversion operated in cycles with timing dependent on the output voltage, the method comprising:

counting the number of cycles during which the DC/DC conversion is operated; and
deriving a current consumption of the DC/DC converter from the number of cycles.

This method monitors the current flow used by the DC/DC converter based on a count of the number of cycles of the DC/DC converter. The current flow can be derived with simple circuitry.

A battery can supply current to a load through the DC/DC conversion, and the method further comprises deriving a state of charge of the battery from the number of cycles.

This method monitors the current flow from the battery (i.e. to the DC/DC converter) based on the way the output has discharged to the load, which in turn influences the number of cycles of the DC/DC converter. In this way, the state of charge can be derived with simple circuitry which can be internal to the device operated by the battery. If a battery supplies multiple DC/DC converters, then the combined input current consumptions of the DC/DC converters will then be used to derive the battery charge. Similarly, the current consumption of other devices supplied by the battery can also be taken into account if necessary.

In this aspect, the invention is based on the recognition that the input current consumption of a DC/DC converter, for example when supplied by a battery, can be used to provide an indication of the state of charge of the battery. This enables a warning to be provided to a user that the battery is close to empty. Such a warning is for example of interest for users of hearing aids.

The method can further comprise generating a battery charge level message based on the derived state of charge.

The method can be used for determining the battery life of a hearing aid battery. This application requires low power and low volume circuitry, and the simple approach of counting cycles in accordance with the invention is of particular interest for hearing aids.

Counting the number of cycles can comprise switching a ripple counter.

The number of cycles can be cumulatively added for fixed time intervals, thereby deriving a total number of cycles for the battery. This total number is representative of a total charge flow from the battery, but the counter can be reset periodically to limit the size of the counter.

The invention also provides a circuit for determining the current consumption of a capacitive DC/DC converter which is operated in cycles with timing dependent on the output voltage, comprising:

a counter for counting the number of cycles during which the capacitive DC/DC converter is operated; and means for deriving an input current consumption of the DC/DC converter from the number of cycles.

A battery circuit for determining the battery life of a battery can comprise a battery; the capacitive DC/DC converter which is operated in cycles with timing dependent on the output voltage; and the circuit of the invention used for deriving a state of charge of the battery from the number of cycles.

A hearing aid can comprise a battery circuit of the invention and a hearing aid circuit, with the DC/DC voltage converter supplying the hearing aid circuit.

An example of the invention will now be described in detail with reference to the accompanying drawings, in which:

Figure 1 shows an example of DC/DC converter which can be used by a device having the monitoring circuit and method of the invention;

Figure 2 shows a simplified representation of a generic DC/DC converter;

Figures 3a and 3b show the capacitor configurations for a conversion ratio of 1/2 and the calculations of effective resistance;

Figures 4a and 4b show the capacitor configurations for a conversion ratio of 2/3 and the calculations of effective resistance;

Figures 5a and 5b show the capacitor configurations for a conversion ratio of 3/4 and the calculations of effective resistance;;

Figures 6a and 6b show the capacitor configurations for a conversion ratio of 1 and the calculations of effective resistance;

Figure 7 shows a circuit using six of the modules of Figure 1; and

Figure 8 shows a circuit of the invention and is used to explain the method of the invention.

The invention provides a method of determining the input current consumption of a capacitive DC/DC converter. This can be used for example to predict the battery life of a battery which supplies current to a load through the capacitive DC/DC converter. The converter is operated in cycles with timing dependent on the output voltage. The number of cycles during which the DC/DC converter is operated is counted and the current is derived from the number of cycles.

An example of DC/DC converter is discussed above with reference to Figure 1.

In the case of a hearing aid, since no external components are allowed, a capacitive DC/DC converter is often used for the digital core. The switches and capacitor as shown in Figure 1 are on-chip, and the output is externally decoupled with a capacitor (such as 470nF).

Capacitive converters are most efficient when the output voltage is a fixed ratio or multiple of the input voltage. However, the digital core consumes the least current when the supply voltage is as low as possible. For this reason, the converter should have a conversion ratio, depending on the battery voltage and load current, in which the output voltage is made as close as possible above the target supply voltage for the digital core.

A voltage drop is provided to create the voltage difference between the DC/DC converter output and the target voltage. One common method to create this voltage drop in a feedback loop is a so-called clock-gating mode.

In the clock-gating mode, the DC/DC converter switches when the output voltage is below the target and stops switching when the output voltage is above the target. This mode has the advantage that it is very efficient for all load currents.

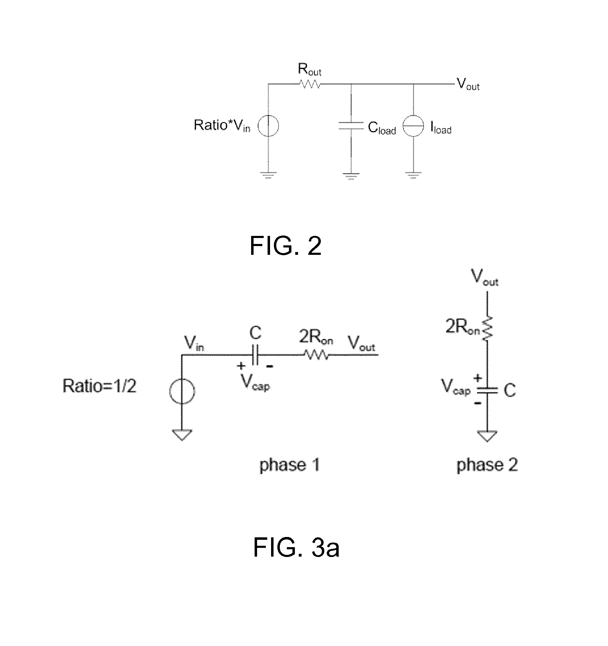

The converter can be modelled as a voltage source of ratio*Vin and a certain output impedance Rout as shown in Figure 2. The converter drives a capacitive load Cload which draws current Iload.

In the case of a battery supply driving a digital core, Vin=Vbat and Vout=Vcore.

The converter is operated in two phases, in which the switching capacitors are connected differently to or between the input voltage, the output voltage or ground. Various ratios can be implemented between the input and output by using capacitors in different configurations.

In a simplest implementation, the DC/DC converter can have a single capacitor (as in Figure 1) but it can instead have multiple capacitors to enable different ratios to be implemented.

The capacitor configurations in the two phases to implement a selection of different ratios are shown below.

A DC/DC converter can be configurable to different ratios by having a suitable capacitor and switch network, so that the switches can implement different capacitor configurations. In the examples below, the ratio is 1 or less, so that the DC/DC converter is down-converting the battery voltage. Charge pump DC/DC converters can also increase the voltage, and the approach of the invention can be applied to up-converting DC/DC converters.

For ratio=1/2 (i.e. Vout = 0.5Vin) the phases are shown in Figure 3a.

In a first phase, a storage capacitor is in series between the input and output so that when charged to a steady state, the voltage Vout is across the capacitor. The second phase directly follows the first phase, and the storage capacitor is then between the output and ground and provides the output voltage Vout. As soon as the output voltage drops to a particular level, because the capacitor discharges to the load, the circuit carries out another cycle (or set of cycles) of the two phases, to recharge the capacitor.

The switching frequency between the two phases stays the same, and all switching is stopped while the output voltage remains high enough. Once the output has dropped in voltage to the switching threshold, a switching cycle is carried out once more.

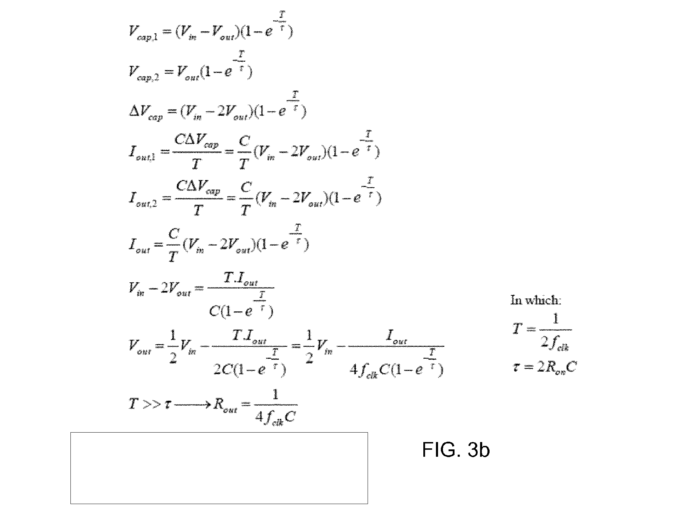

The output impedance for this DC/DC converter ratio can be calculated as shown in Figure 3b.

The output impedance is calculated for full charging so that T>>τ. This is the output impedance for the clock-gating mode.

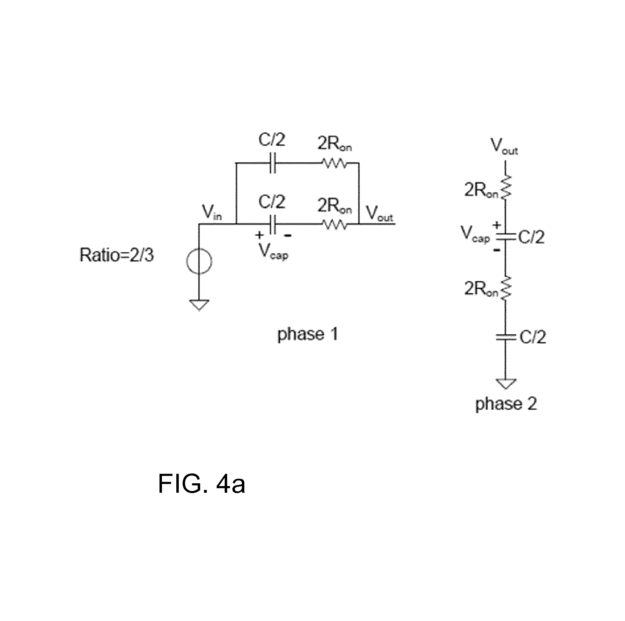

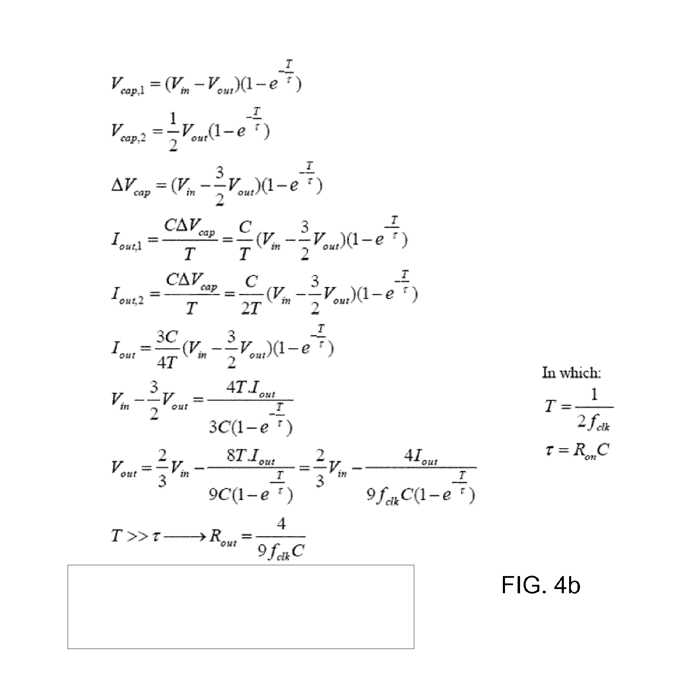

For ratio=2/3 the phases and calculations are shown in Figures 4a and 4b. In this case, there are two capacitors switched to two different connection configurations.

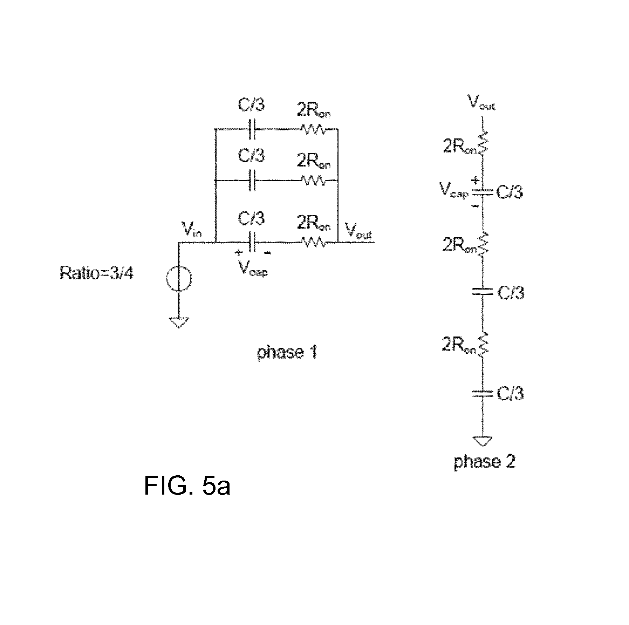

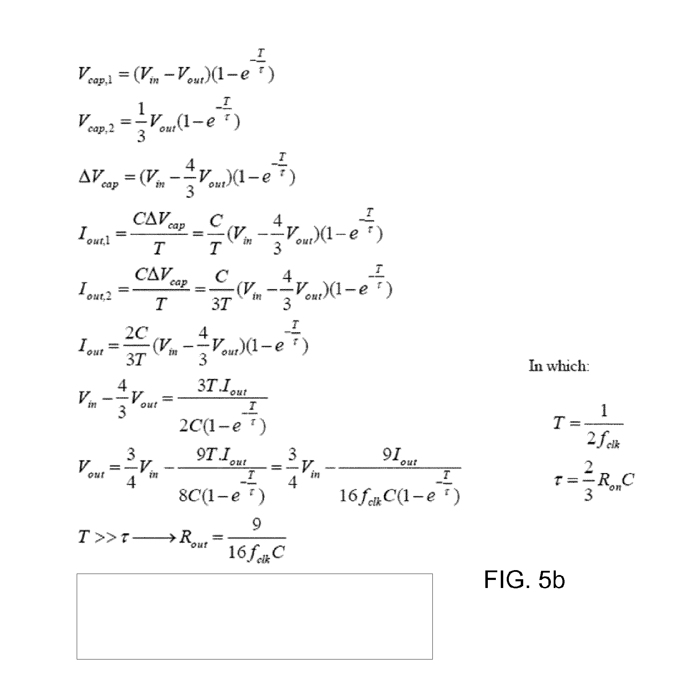

For ratio=3/4 the phases and calculations are shown in Figures 5a and 5b. In this case, there are three capacitors switched to two different connection configurations.

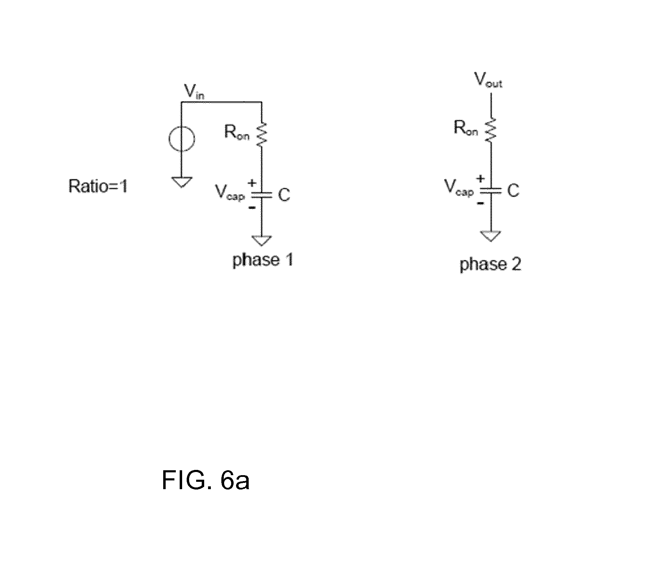

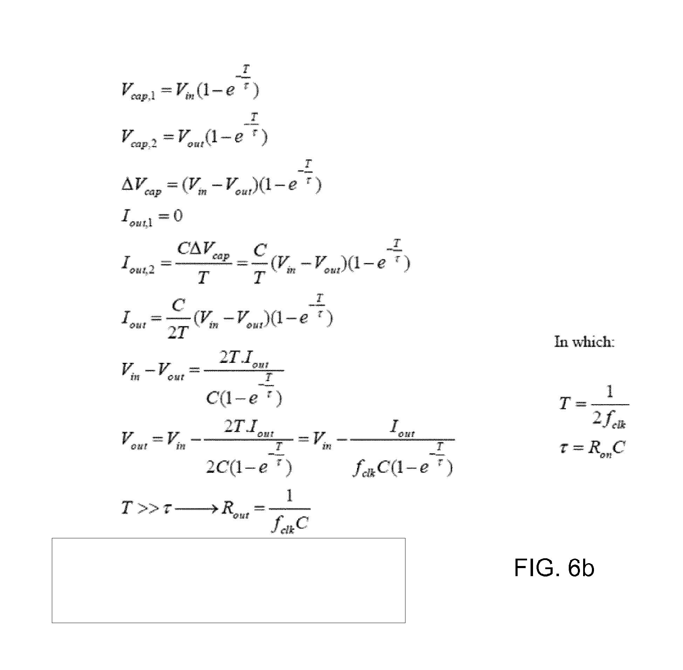

For ratio=1 the phases and calculations are shown in Figures 6a and 6b. In this case, there is a single capacitor switched to two different connection configurations.

As mentioned above, a circuit can be configurable to define different conversion ratios. For example, the circuit of Figure 1 can be used as one module within a multi-module circuit. This then enables the overall circuit to be tuneable to different conversion ratios, such as those shown above.

In Figure 1 the capacitor is shown as C/N to indicate that the circuit is repeated N times to implement an overall switching capacitance of C. The module (section n) can be connected to a preceding module (section n-1) and a succeeding module (section n+1). As shown in Figure 1, a controller 20 determines the setting of the various switches sw1-sw6 in response to the conversion ratio being implemented.

The capacitors C/N can be internal as mentioned above, but they can also be external if the particular use of the circuit allows. Of course, external capacitors can be larger, which enables the switching frequencies to be relaxed.

The voltage feedback loop is controlled by regulating the frequency of the clock gating signal fsw. As explained above for Figure 1, this is done by the comparator that gates the clock $f_{clk}$ when the output voltage $V_{out}$ is higher than the reference Vref and lets the converter switch when $V_{out}$ is lower than the reference. An alternative is to regulate the frequency $f_{sw}$.

As shown in Figures 3 to 6, the model of the converter shown in Figure 2 has the following characteristics:

$$R_{out} = \frac{Ratio^2}{f_{sw}.C} \text{ for Ratio lower than or equal to 1} \qquad (1)$$

It can be shown by corresponding analysis to that given for Ratio less than or equal to 1 that the output resistance takes the form:

$$R_{out} = \frac{1}{f_{sw}.C} \text{ for Ratio higher than 1} \qquad (2)$$

In which C is the total switching capacitance.

The clock gating signal frequency can be defined as:

$$f_{sw} = \alpha \cdot f_{clk} \qquad (3)$$

In which $\alpha$ is the average switching frequency that results from the control loop.

The output voltage can thus be calculated as a function of the parameters of the DC/DC converter:

$$V_{out} = Ratio \cdot V_{in} - I_{load} \cdot R_{out} \tag{4}$$

Here, the output voltage to the core is equal to the DC/DC converter output less the voltage drop across the series output impedance (as seen in Figure 2).

Rewriting for $I_{load}$:

$$I_{load} = \frac{Ratio \cdot V_{in} - V_{out}}{V_{out}} \tag{5}$$

Using (1), (2), (3) and $I_{in} = Ratio \cdot I_{load}$ (since the current scales inversely with voltage to conserve energy),:the input current (which is what we want to know) is defined as:

$$I_{in} = \frac{f_{sw} \cdot C}{Ratio} (Ratio. V_{in} - V_{out}) = \alpha. \frac{f_{clk} \cdot C}{Ratio} (Ratio. V_{in} - V_{out})$$

for Ratio lower than or equal to 1 $\hspace{3cm}$ (6)

$$I_{in} = Ratio. f_{sw}. C (Ratio. V_{in} - V_{out}) = \alpha. Ratio. f_{clk}. C (Ratio. V_{in} - V_{out})$$

for Ratio higher than 1 $\hspace{3cm}$ (7)

In these equations Ratio, C, $f_{clk}$ and $V_{out}$ are known. $V_{in}$ can be measured on-chip with e.g. an analogue to digital converter.

If the value of $\alpha$ can be measured (the average switching frequency), it is possible to calculate how much input current a certain load current requires.

These equations indicate the average current drawn from the input for one cycle of the DC/DC converter. The average switching frequency is used to convert this average current into a current consumption value.

The number of cycles of the DC/DC converter thus enables the overall current consumption to be obtained (in units of current x time, such as mAh).

This means that by measuring the input current to the converter - which is purely a function of the number of recharge operations of the converter capacitance, it is possible to monitor the output current supplied to the load. This in turn enables the state of battery charge to be determined, since the battery has a finite and known current capacity.

The required counting can for example be done by e.g. a counter (which can be implemented as a ripple counter) that counts the number of clocks of $f_{sw}$ in a certain amount of time. The ratio $\alpha$ can be calculated by dividing the resulting count value by the number of $f_{clk}$ clocks in the counting period.

It is noted that the equations for Rout given above apply to certain capacitor configurations and their respective conversion ratios only. In particular, these equations are valid for conversion ratios 1/2, 2/3, 3/4, 1 (the calculations for which are given in Figures 3 to 6) and also for conversion ratios 4/3, 3/2, 2, 3. The equations for resistance for these ratios can be derived in the same way as shown in Figures 3 to 6, and the capacitor configurations will be known to those skilled in the art. For other ratios, the formulas will need to be adapted accordingly. However, for a given circuit configuration, calculation of the output impedance is a routine matter.

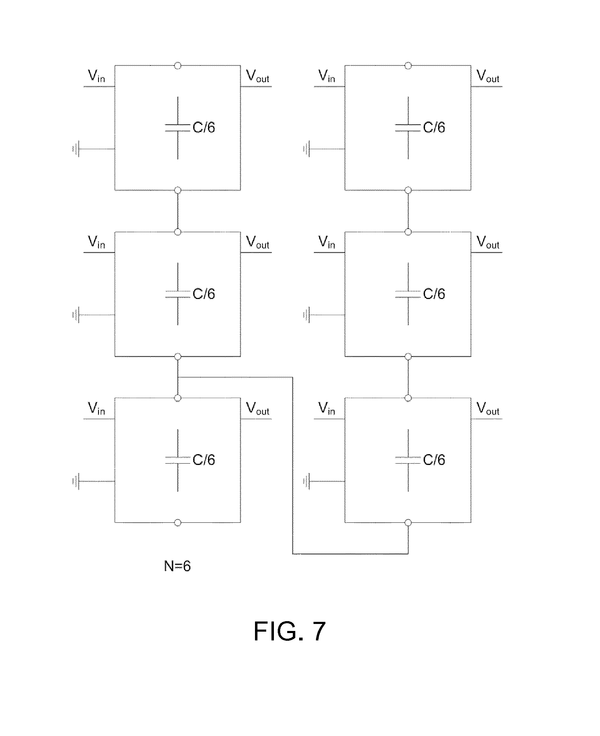

Figure 7 shows 6 modular sections (N=6) coupled together. With suitable control of the switches, this circuit can implement ratios: ½, 2/3, ¾, 1, 4/3, 3/2, 2.

The total capacitance in this example is C and the output impedance calculation is based on this total capacitance C.

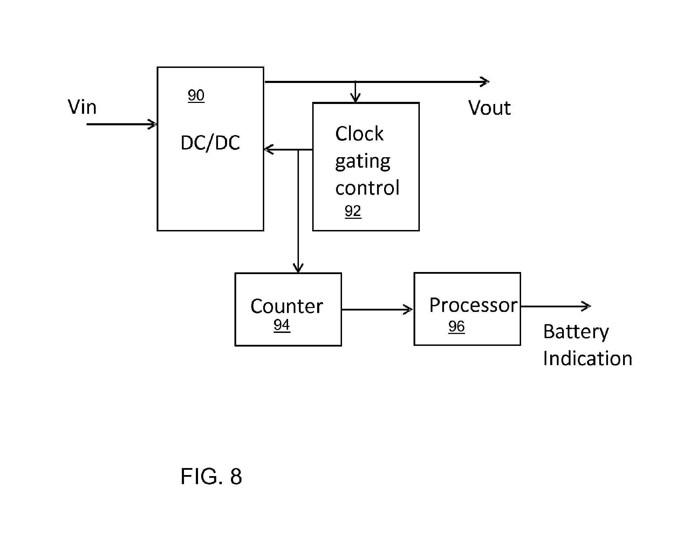

Figure 8 shows a system of the invention.

The capacitive DC/DC converter is shown as 90, and a feedback system 92 provides clock gating control, to provide a gated clock signal at the switching frequency fclk. This gated clock signal is provided to a counter 94 which counts the number of gated clock cycles.

A running total is kept, but the counter may function for a fixed time interval (for example determined as a fixed number of non-gated clock pulses at the clock frequency fclk) and be reset after each time interval. The counter can for example be implemented as a ripple counter, such as a binary weighted ripple counter. A ripple counter comprises a cascade of latches. By way of example, a 26 bit binary weighted ripple counter can count the clock cycles in a period of around 1 second for a 20 MHz clock.

The overall count value can be processed to derive a battery level indication using processor 96. This takes account of the initial battery capacity  (again in units of current x time). In this way, a warning can be provided when a battery approaches the end of its life, and/or a continuous battery level indication.

This battery level information can be sent wirelessly from the device to a remote base unit to provide the information to a user. Alternatively, the information can be used simply to control a warning signal, for example in the form of audible beeps provided to the user.

All of the units in Figure 8 can be internal to a hearing aid.

As mentioned above, one area of interest for the invention is hearing aids. However, the invention can be applied to other battery operated devices where advance warning of battery usage is desirable, such as mobile phones.

By way of example, the switching frequency fclk can typically be of the order of ones or tens of MHz. The switching frequency is related to the capacitance value. For small internal capacitors, several tens of MHz is typical, whereas for larger external capacitors lower frequencies of operation will be used.

Various modifications will be apparent to those skilled in the art.

## Claims

1. A method of determining the input current consumption of a capacitive DC/DC conversion operated in cycles with timing dependent on the output voltage, the method comprising:

   counting (94) the number of cycles during which the DC/DC conversion is operated; and
   deriving the input current consumption of the DC/DC converter from the number of cycles.

2. A method as claimed in claim 1, wherein a battery supplies current to a load through the DC/DC conversion, and the method further comprises deriving a state of charge of the battery from the number of cycles.

3. A method as claimed in claim 2, further comprising generating a battery charge level message based on the derived state of charge.

4. A method as claimed in claim 3, wherein the message comprises an audible message when the state of reach reaches a predetermined level.

5. A method as claimed in claim 2, 3 or 4, for determining the battery life of a hearing aid battery.

6. A method as claimed in any preceding claim, wherein counting the number of cycles comprises switching a ripple counter.

7. A method as claimed in any preceding claim, wherein the number of cycles is cumulatively added after fixed time intervals, thereby deriving a total number of cycles.

8. A circuit for determining the current consumption of a capacitive DC/DC converter (90) which is operated in cycles with timing dependent on the output voltage, comprising:

   a counter (94) for counting the number of cycles during which the capacitive DC/DC converter is operated; and
   means (96) for deriving an input current consumption of the DC/DC converter from the number of cycles.

9. A battery circuit for determining the battery life of a battery, comprising:

   a battery;
   a capacitive DC/DC converter (90) which is operated in cycles with timing dependent on the output voltage; and
   a circuit as claimed in claim 8 for deriving a state of charge of the battery from the number of cycles.

10. A circuit as claimed in claim 9, further comprising an output unit (96) for generating a battery charge level message based on the derived state of charge.

11. A circuit as claimed in claim 9 or 10, wherein the battery comprises a hearing aid battery.

12. A circuit as claimed in any one of claims 8 to 11, comprising a ripple counter for counting the number of cycles.

13. A circuit as claimed in any one of claims 8 to 11, comprising means for cumulatively adding the number of cycles after each fixed time interval, thereby deriving a total number of cycles for the battery.

14. A hearing aid comprising a battery circuit as claimed in any one of claims 9 to 13, and a hearing aid circuit, wherein the capacitive DC/DC converter supplies the hearing aid circuit.

FIG. 1

FIG. 2

FIG. 3a

$$V_{cap,1} = (V_{in} - V_{out})(1 - e^{-\frac{T}{\tau}})$$

$$V_{cap,2} = V_{out}(1 - e^{-\frac{T}{\tau}})$$

$$\Delta V_{cap} = (V_{in} - 2V_{out})(1 - e^{-\frac{T}{\tau}})$$

$$I_{out,1} = \frac{C\Delta V_{cap}}{T} = \frac{C}{T}(V_{in} - 2V_{out})(1 - e^{-\frac{T}{\tau}})$$

$$I_{out,2} = \frac{C\Delta V_{cap}}{T} = \frac{C}{T}(V_{in} - 2V_{out})(1 - e^{-\frac{T}{\tau}})$$

$$I_{out} = \frac{C}{T}(V_{in} - 2V_{out})(1 - e^{-\frac{T}{\tau}})$$

$$V_{in} - 2V_{out} = \frac{T.I_{out}}{C(1 - e^{-\frac{T}{\tau}})}$$

In which:

$$V_{out} = \frac{1}{2}V_{in} - \frac{T.I_{out}}{2C(1 - e^{-\frac{T}{\tau}})} = \frac{1}{2}V_{in} - \frac{I_{out}}{4f_{clk}C(1 - e^{-\frac{T}{\tau}})}$$

$$T = \frac{1}{2f_{clk}}$$

$$\tau = 2R_{on}C$$

$$T \gg \tau \longrightarrow R_{out} = \frac{1}{4f_{clk}C}$$

FIG. 3b

FIG. 4a

$$V_{cap,1} = (V_{in} - V_{out})(1 - e^{-\frac{T}{\tau}})$$

$$V_{cap,2} = \frac{1}{2}V_{out}(1 - e^{-\frac{T}{\tau}})$$

$$\Delta V_{cap} = (V_{in} - \frac{3}{2}V_{out})(1 - e^{-\frac{T}{\tau}})$$

$$I_{out,1} = \frac{C\Delta V_{cap}}{T} = \frac{C}{T}(V_{in} - \frac{3}{2}V_{out})(1 - e^{-\frac{T}{\tau}})$$

$$I_{out,2} = \frac{C\Delta V_{cap}}{T} = \frac{C}{2T}(V_{in} - \frac{3}{2}V_{out})(1 - e^{-\frac{T}{\tau}})$$

$$I_{out} = \frac{3C}{4T}(V_{in} - \frac{3}{2}V_{out})(1 - e^{-\frac{T}{\tau}})$$

$$V_{in} - \frac{3}{2}V_{out} = \frac{4T.I_{out}}{3C(1 - e^{-\frac{T}{\tau}})}$$

$$V_{out} = \frac{2}{3}V_{in} - \frac{8T.I_{out}}{9C(1 - e^{-\frac{T}{\tau}})} = \frac{2}{3}V_{in} - \frac{4I_{out}}{9f_{clk}C(1 - e^{-\frac{T}{\tau}})}$$

$$T \gg \tau \longrightarrow R_{out} = \frac{4}{9f_{clk}C}$$

In which:

$$T = \frac{1}{2f_{clk}}$$

$$\tau = R_{on}C$$

FIG. 4b

FIG. 5a

$$V_{cap,1} = (V_{in} - V_{out})(1 - e^{-\frac{T}{\tau}})$$

$$V_{cap,2} = \frac{1}{3}V_{out}(1 - e^{-\frac{T}{\tau}})$$

$$\Delta V_{cap} = (V_{in} - \frac{4}{3}V_{out})(1 - e^{-\frac{T}{\tau}})$$

$$I_{out,1} = \frac{C\Delta V_{cap}}{T} = \frac{C}{T}(V_{in} - \frac{4}{3}V_{out})(1 - e^{-\frac{T}{\tau}})$$

$$I_{out,2} = \frac{C\Delta V_{cap}}{T} = \frac{C}{3T}(V_{in} - \frac{4}{3}V_{out})(1 - e^{-\frac{T}{\tau}})$$

$$I_{out} = \frac{2C}{3T}(V_{in} - \frac{4}{3}V_{out})(1 - e^{-\frac{T}{\tau}})$$

$$V_{in} - \frac{4}{3}V_{out} = \frac{3T \cdot I_{out}}{2C(1 - e^{-\frac{T}{\tau}})}$$

$$V_{out} = \frac{3}{4}V_{in} - \frac{9T \cdot I_{out}}{8C(1 - e^{-\frac{T}{\tau}})} = \frac{3}{4}V_{in} - \frac{9I_{out}}{16f_{clk}C(1 - e^{-\frac{T}{\tau}})}$$

$$T \gg \tau \longrightarrow R_{out} = \frac{9}{16f_{clk}C}$$

In which:

$$T = \frac{1}{2f_{clk}}$$

$$\tau = \frac{2}{3}R_{on}C$$

FIG. 5b

FIG. 6a

$$V_{cap,1} = V_{in}(1 - e^{-\frac{T}{\tau}})$$

$$V_{cap,2} = V_{out}(1 - e^{-\frac{T}{\tau}})$$

$$\Delta V_{cap} = (V_{in} - V_{out})(1 - e^{-\frac{T}{\tau}})$$

$$I_{out,1} = 0$$

$$I_{out,2} = \frac{C\Delta V_{cap}}{T} = \frac{C}{T}(V_{in} - V_{out})(1 - e^{-\frac{T}{\tau}})$$

$$I_{out} = \frac{C}{2T}(V_{in} - V_{out})(1 - e^{-\frac{T}{\tau}})$$

$$V_{in} - V_{out} = \frac{2T.I_{out}}{C(1 - e^{-\frac{T}{\tau}})}$$

$$V_{out} = V_{in} - \frac{2T.I_{out}}{2C(1 - e^{-\frac{T}{\tau}})} = V_{in} - \frac{I_{out}}{f_{clk}C(1 - e^{-\frac{T}{\tau}})}$$

$$T \gg \tau \longrightarrow R_{out} = \frac{1}{f_{clk}C}$$

In which:

$$T = \frac{1}{2f_{clk}}$$

$$\tau = R_{on}C$$

FIG. 6b

N=6

FIG. 7

FIG. 8

Europäisches
Patentamt

European
Patent Office

Office européen
des brevets

# EUROPEAN SEARCH REPORT

Application Number

EP 12 17 0559

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 959 853 A (KOS MAREK JOHN [US]) 28 September 1999 (1999-09-28) | 1,8 | INV. H02M3/07 |
| Y | * abstract; figure 1 * * column 8, line 25 - line 62 * | 2,6,7,9, 12,13 | G01R31/36 |
| Y | US 4 912 392 A (FAULKNER ANDREW [GB]) 27 March 1990 (1990-03-27) * abstract; figures 1,2 * | 2,7,9,13 | |
| Y | US 4 586 118 A (MIHALKA ALEX M [US]) 29 April 1986 (1986-04-29) * abstract * | 6,12 | |
| A | DE 41 12 987 A1 (BOSCH GMBH ROBERT [DE]) 22 October 1992 (1992-10-22) * abstract * * column 3, line 24 - column 6, line 5; figures 1,2 * | 2,7,9,13 | |

TECHNICAL FIELDS
SEARCHED (IPC)

H02M
G11C
G01R
H02J

The present search report has been drawn up for all claims

| Place of search | Date of completion of the search | Examiner |
|---|---|---|
| Munich | 7 November 2012 | Braccini, Roberto |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 12 17 0559

This annex lists the patent family members relating to the patent documents cited in the above-mentioned European search report.
The members are as contained in the European Patent Office EDP file on
The European Patent Office is in no way liable for these particulars which are merely given for the purpose of information.

07-11-2012

| Patent document cited in search report | | Publication date | Patent family member(s) | | Publication date |
|---|---|---|---|---|---|
| US 5959853 | A | 28-09-1999 | NONE | | |
| US 4912392 | A | 27-03-1990 | FR | 2605415 A1 | 22-04-1988 |
| | | | GB | 2199148 A | 29-06-1988 |
| | | | US | 4912392 A | 27-03-1990 |
| US 4586118 | A | 29-04-1986 | NONE | | |
| DE 4112987 | A1 | 22-10-1992 | AT | 405886 B | 27-12-1999 |
| | | | CH | 683209 A5 | 31-01-1994 |
| | | | DE | 4112987 A1 | 22-10-1992 |
| | | | ES | 2036958 A2 | 01-06-1993 |
| | | | IT | 1258313 B | 22-02-1996 |

EPO FORM P0459

For more details about this annex : see Official Journal of the European Patent Office, No. 12/82